# EUROPEAN PATENT APPLICATION

(11) **EP 2 677 553 A1**
(43) Date of publication of application: **25.12.2013**
(21) Application number: 13173269.5
(22) Date of filing: 21.06.2013
(51) Int. Cl.: H01L 31/048, B32B 17/10

(54) **Flexible solar cell assembly and use of the same**

(30) Priority: 21.06.2012 CN 201220296346 U
(71) Applicant: Changchun Sun Windows Technology Co. Ltd, 130103 Changchun Jilin (CN)
(72) Inventor: Yan, Chi, 130022 Changchun (CN)
(74) Representative: Jansen, Cornelis Marinus

(57) **Abstract**

The present invention provides a flexible solar cell assembly, which comprises a lower glass layer (1), a lower polyvinyl butyral (PVB) layer (2), a translucent flexible thin film solar cell (3), an upper polyvinyl butyral (PVB) layer (4), an upper glass layer (5) consecutively laminated and closely connected from top to bottom; wherein the translucent flexible thin film solar cell (3) is an amorphous silicon flexible thin film solar cell or an organic flexible thin film solar cell. The translucent flexible thin film solar cell is an amorphous silicon flexible thin film solar cell, a compound semiconductor flexible thin film solar cell, or an organic flexible thin film solar cell, which can be processed into arc structure without being broken into pieces and has a light transmittance of 10-40%, which meets the requirements on feasibility of production and transmittance simultaneously. The flexible solar cell assembly can be used for full-view top of the vehicles. By connecting the electrodes of the flexible solar cell assembly with the circuit of a vehicle-mounted apparatus or a battery, the solar cell assembly can achieve supplying current to the car or electric power storage so as to save the electric energy.

## Description

### TECHNICAL FIELD

The present invention relates to a flexible solar cell assembly and use of the same.

### BACKGROUND OF THE INVENTION

In recent years, with the perfection of solar cell technology, the application field thereof gradually extends, wherein vehicle-mounted solar cell has become a hot spot. The power generated by the vehicle-mounted solar cell supplies for other electronic products in the car, and charges the vehicle battery in the meantime to achieve the aim of the reduction of oil consumption and the aim of clean and environmental protection.

Currently, vehicle-mounted solar cells are mainly mounted on top of the vehicles (see Chinese patent application CN1794472A). Since geometric shape of the vehicles' top is irregular and the solar plates in prior art usually use monocrystalline silicon or polycrystalline silicon cells with high brittleness, the solar cell plates are easy to be damaged during the integrating process.

To solve the above problem, Chinese patent application CN101192630A adopts the method of assembly, which means assembling together a few small solar cell plates, while avoiding irregular geometric shape area. The method requires designing different assembly solutions for different vehicle models, increasing the difficulty of assembly production.

To avoid using the method of assembly, Chinese patent application CN101478011A provides a flexible solar cell assembly and the production method thereof. The flexible solar cell is used in the process to avoid the damage on cells when producing complex structures, such as arc shape, etc. However, the method adopts the flexible solar cell assembly with 7-layers structures and thus is too complicated. Meanwhile, the assembly provided by the method only has two layers of plastics on the bottom part of the solar cell, which makes the assembly readily to be damaged as a result of scratching during using.

Chinese patent application CN101973324A provides a 5-layers sandwich glass comprising solar cell, which simplifies the structure and protects the solar cells. However, it is not clearly disclosed that the solar cell used therein is flexible solar cell.

Chinese patent application CN201511916U provides a technical solution coating a solar cell film for light conversion on the surface of an arc-shaped light transmission plate. However, since the light transmission plate has an irregular shape, there will be huge difficulties in the production of the solar cell.

On the other hand, with the expansion in people's requirements, a full-view car is favored gradually. The top of this type of car is made of a transparent or translucent glass, allowing those in the car a broader view. Monocrystalline silicon or polycrystalline silicon solar cells are mostly used in the prior art, which are too low in light transmittance to meet this kind of requirements.

Chinese patent application CN201802257U proposes to use a thin film solar cell to solve the above problem. However, similarly, the patent does not clearly disclose that the solar cells used therein are flexible solar cell.

Thus, there is still a need to provide a flexible solar cell assembly which can meet above requirements.

### SUMMARY OF THE INVENTION

For solving the problem existing in prior art that there is no any solar cell assembly meeting the requirements on both feasibility of production and light transmittance, the present invention provides a flexible solar cell assembly and the use thereof.

As one aspect, the present invention provides a flexible solar cell assembly, which comprises an upper glass layer, an upper polyvinyl butyral (PVB) layer, a translucent flexible film solar cell, a lower polyvinyl butyral (PVB) layer and a lower glass layer consecutively laminated from top to bottom; wherein the translucent flexible film solar cell is preferably amorphous silicon flexible thin film solar cell, compound semiconductor flexible thin film solar cell, or organic flexible thin film solar cell. The flexible solar cell assembly according to the present invention uses a translucent flexible film solar cell and has a light transmittance of 10-40%, which meets the requirements on feasibility of production and light transmittance simultaneously. Unless otherwise indicated, the term "flexible film" or "flexible thin film" means a thin film which can generate deformation such as bend, distortion, etc. which would not disrupt the structure and performance of the thin film per se, under the action of external force less than a critical value, and can partly or completely restore to the state prior to the appliance of the external force, after withdrawing the external force. When the external force exceeds the critical value, the structure and performance of the thin film are disrupted. The thin films of different materials correspond to different critical value. The term "compound semiconductor" means a semiconductor composed of two or more elements, for example, GaAs, CuInGaSe2 (CIGS) and so on.

As another aspect, the present invention provides a use of the flexible solar cell assembly in the applications which need a high light transmittance, for example, vehicles.

As a yet another aspect, the present invention provides a vehicle comprising a full view top made of the flexible solar cell assembly.

### BRIEF DESCRIPTION OF THE FIGURES

FIG. 1 is a schematic perspective view of the structure of the flexible solar cell assembly provided in the present invention; and

FIG. 2 is a schematic view of integration of the flexible solar cell assembly provided in the present invention with the car body.

### DETAILED DESCRIPTION OF THE INVENTION

The present invention provides a method for producing the flexible solar cell assembly, comprising:
(1) softening the upper and lower glass layers upon heating, followed by using mould to process them into needed shape, wherein the shaped upper glass layer has a concave inner surface and the shaped lower glass layer has a convex outer surface;
(2) adhering the upper PVB layer onto the concave inner surface of the shaped upper glass layer and adhering the lower PVB layer onto the convex outer surface of the shaped lower glass layer;
(3) providing a translucent flexible film solar cell between the upper PVB layer adhered onto the upper glass layer and the lower PVB layer adhered onto the lower glass layer to form a green flexible solar cell assembly, wherein the solar cell contacts the PVB layers;
(4) pre-curing the green flexible solar cell assembly obtained from step (3) in a vacuum of no more than 100Pa, at 140-160 C, and then maintaining the temperature for 2-4 hours till completely cured to obtain cured flexible solar cell assembly;
(5) optionally, for preventing water and dust, sealing around the periphery of the cured flexible solar cell assembly with sealing materials, to obtain a sealed flexible solar cell assembly.

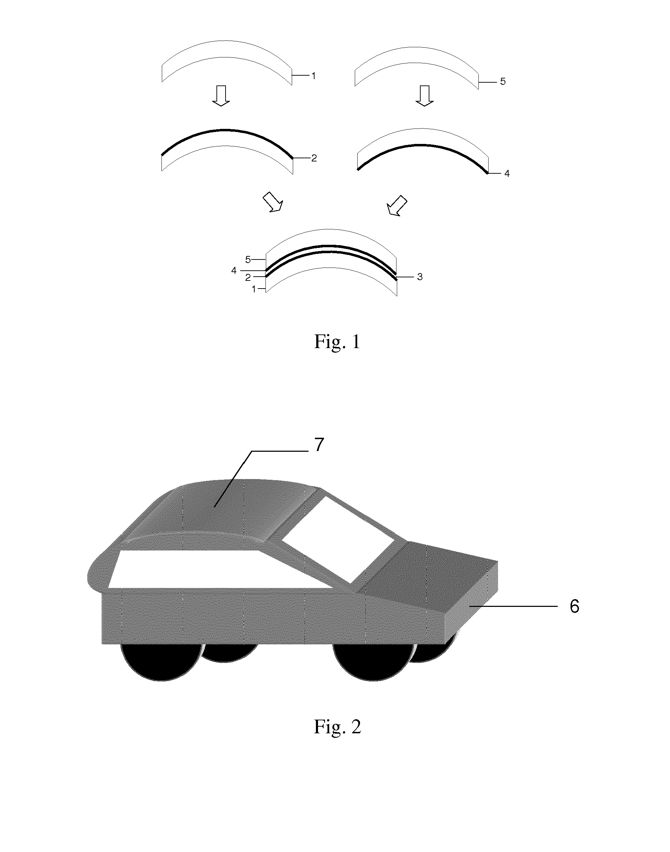

The flexible solar cell assembly provided in the present invention can be processed into that having arc structure, which can be applied to full-view top of the car. Connecting the electrodes of the flexible solar cell assembly with the circuit of a vehicle-mounted apparatus or a battery can achieve supplying current to the car or electric power storage. FIG. 2 is a schematic view of integrating the flexible solar cell assembly provided in the present invention with the car body, wherein 6 is car body, 7 is a five-layer structured flexible solar cell assembly as the top of the full-view car.

The translucent flexible thin film solar cell of the flexible solar cell assembly provided in the present invention is an amorphous silicon flexible thin film solar cell or an organic flexible thin film solar cell, which can be processed into an arc structure without being broken into pieces. Due to the use of a translucent flexible thin film solar cell, the present invention provides a flexible solar cell assembly with a light transmittance of 10-40%, meeting the requirements on feasibility of production and transmittance simultaneously.

The flexible solar cell assembly provided in the present invention can be applied to produce full-view top of the car. By connecting the electrodes of the flexible solar cell assembly with the circuit of a vehicle-mounted apparatus or a battery, the flexible solar cell assembly can achieve supplying current to the car or electric power storage so as to save the electric energy.

### Examples

**Example 1**

As shown in FIG. 1, a flexible solar cell assembly comprises a lower glass layer 1, a lower polyvinyl butyral (PVB, available from Sekisui Chemical Co., LTD, with the model of S-LEC SAF (Soun Acoustic Film)) layer 2, a translucent flexible thin film solar cell 3, an upper polyvinyl butyral (PVB) layer 4, an upper glass layer 5 consecutively laminated and closely connected from top to bottom; wherein the translucent flexible thin film solar cell 3 is an amorphous silicon flexible thin film solar cell or an organic flexible thin film solar cell. Due to the use of translucent flexible thin film solar cell, the present invention provides a flexible solar cell assembly with a light transmittance of 10-40% (as determined using Type Jasco 570 UV-V-IR spectrometer from Jasco) that meets the requirements on feasibility of production and transmittance simultaneously.

The translucent flexible thin film solar cell 3 used are SG-NH100-GS model amorphous silicon flexible thin film solar cell available from HENAN SUNGEN SOLAR FAB CO. LTD. The procedure of the preparing process thereof: (1) a transparent conductive oxide (TCO) is prepared on the surface of a flexible glass as a first electrode of the cell by using magnetron sputtering, and processed to the required pattern using laser etching process; (2) a semi-conductive layer is prepared using Plasma Enchanced Chemical Vapor Deposition (PECVD), and processed to the required pattern using laser etching process; (3) a second electrode (back electrode) is prepared using magnetron sputtering, and processed to the required pattern using laser etching process; (4) It can be used after laser edge deleting and ablation test.

The translucent flexible thin film solar cell 3 used could also be organic flexible thin film solar cell, or compound semiconductor flexible thin film solar cell. The organic flexible thin film solar cell be prepared as follows: (1) a transparent conductive oxide (TCO) is prepared on the surface of a flexible glass as a first electrode of the cell by using magnetron sputtering, and processed to the required pattern using laser etching process; (2) a first electrode modifying layer, a organic semi-conductive layer and a second electrode modifying layer are manufactured successively by blade coating process or inkjet printing process; (3) a second electrode is manufactured by screen printing or blade coating process, and the organic flexible thin film solar cell is formed eventually. The compound semiconductor flexible thin film solar cell be prepared as follows: (1) a transparent conductive oxide (TCO) is prepared on the surface of a flexible glass as a first electrode of the cell by using magnetron sputtering, and processed to the required pattern using laser etching process; (2) a compound semi-conductive layer is manufactured using vacuum deposition or magnetron sputtering, and then processed to the required pattern using laser etching process; (3) a second electrode (back electrode) is manufactured using magnetron sputtering, following processing to the required pattern using laser etching process, and the compound semiconductor flexible thin film solar cell is formed eventually.

The steps and conditions of the method for producing flexible solar cell assembly provided in the present invention were as follows:
(1) softening the lower glass layer 1 and the upper glass layer 5 by heating, followed by using a mould to mold them into needed shape, wherein the shaped lower glass layer 1 has a convex outer surface and the shaped upper glass layer 5 has a concave inner surface;
(2) adhering the lower PVB layer 2 onto the convex outer surface of the shaped lower glass layer 1 and adhering the upper PVB layer 4 onto the concave inner surface of the shaped upper glass 5;
(3) providing the translucent flexible thin film solar cell 3 between the lower PVB layer adhered onto the lower glass layer 1 and the upper PVB layer adhered onto the upper glass layer 5 to make the cell contact the PVB layers to form a green flexible solar cell assembly;
(4) pre-curing the green flexible solar cell assembly obtained from step (3) in a vacuum no more than 100Pa, at 140-160 °C, and then maintaining the temperature for 2-4 hours till completely cured to obtain the cured flexible solar cell assembly;
(5) for preventing water and dust, sealing around the periphery of the cured flexible solar cell assembly with sealing materials, to obtain the sealed flexible solar cell assembly.

In the above detailed description, reference is made to the accompanying drawings, which form a part thereof. In the drawings, similar symbols typically identify similar components, unless context dictates otherwise. The illustrative embodiments described in the detailed description, drawings, and claims are not meant to be limiting. Other embodiments may be used, and other changes may be made, without departing from the spirit or scope of the subject matter presented herein. It will be readily understood that the aspects of the present disclosure, as generally described herein, and illustrated in the Figures, can be arranged, substituted, combined, separated, and designed in a wide variety of different configurations, all of which are explicitly contemplated herein.

The present disclosure is not to be limited in terms of the particular embodiments described in this application, which are intended as illustrations of various aspects. Many modifications and variations can be made without departing from its spirit and scope, as will be apparent to those skilled in the art. Functionally equivalent methods and apparatuses within the scope of the disclosure, in addition to those enumerated herein, will be apparent to those skilled in the art from the foregoing descriptions. Such modifications and variations are intended to fall within the scope of the appended claims. The present disclosure is to be limited only by the terms of the appended claims, along with the full scope of equivalents to which such claims are entitled. It is also to be understood that the terminology used herein is for the purpose of describing particular embodiments only, and is not intended to be limiting.

As used in this document, the singular forms "a", "an" and "the" include plural references unless the context clearly dictates otherwise. Unless defined otherwise, all technical and scientific terms used herein have the same meanings as commonly understood by one of ordinary skill in the art. Nothing in this disclosure is to be construed as an admission that the embodiments described in this disclosure are not entitled to antedate such disclosure by virtue of prior invention. As used in this document, the term "comprising" means "including, but not limited to", and can be used interchangeably with "including" or "containing".

While the method and device are described in terms of "comprising" various components or steps (interpreted as meaning "including, but not limited to"), the method, and device can also "consist essentially of" or "consist of" the various components and steps, and such terminology should be interpreted as defining essentially closed-member groups.

Various of the above-disclosed and other features and functions, or alternatives thereof, may be combined into many other different systems or applications. Various presently unforeseen or unanticipated alternatives, modifications, variations or improvements therein may be subsequently made by those skilled in the art, each of which is also intended to be encompassed by the disclosed embodiments.

## Claims

1. A flexible solar cell assembly, comprising a lower glass layer (1), a lower polyvinyl butyral (PVB) layer (2), a translucent flexible thin film solar cell (3), an upper polyvinyl butyral (PVB) layer (4), an upper glass layer (5) consecutively laminated and closely connected from top to bottom.

2. The flexible solar cell assembly according to claim 1, wherein the translucent flexible thin film solar cell (3) is an amorphous silicon flexible thin film solar cell, compound semiconductor flexible thin film solar cell or an organic flexible thin film solar cell.

3. The flexible solar cell assembly according to claim 1, wherein the translucent flexible thin film solar cell (3) is an amorphous silicon flexible thin film solar cell.

4. The flexible solar cell assembly according to claim 1, wherein it is a flexible solar cell assembly sealed with a sealing material.

5. The use of the flexible solar cell assembly according to any one of claims 1 to 4 in articles needing electric energy.

6. The use according to claim 5, wherein the article is a vehicle.

7. The use according to claim 6, wherein the vehicle is a car with a full view top.

8. A vehicle comprising a full view top made of the flexible solar cell assembly according to any one of claims 1 to 4.

9. The vehicle according to claim 8, wherein the vehicle is a car.
